# EUROPEAN PATENT APPLICATION

(11) **EP 4 621 366 A1**
(43) Date of publication of application: **24.09.2025**
(21) Application number: 23891612.6
(22) Date of filing: 15.11.2023
(51) Int. Cl.: G01H 11/08, G01M 99/00, H10N 30/06, H10N 30/30, H10N 30/87

(54) **EQUIPMENT STATE MONITORING SYSTEM**

(30) Priority: 17.11.2022 JP 2022184237
(71) Applicant: DENSO CORPORATION, Kariya-city, Aichi 448-8661 (JP)
(72) Inventor: MAWATARI, Kazuaki, Kariya-city, Aichi 4488661 (JP)
(74) Representative: Kuhnen & Wacker Patent- und Rechtsanwaltsbüro PartG mbB
(86) International application number: PCT/JP2023/041090
(87) International publication number: WO 2024/106465

(57) **Abstract**

A control unit performs a first abnormality determination that compares a detection signal with a first threshold range for grasping a state of an equipment, and determines that the detection signal is abnormal when the detection signal is outside the first threshold range, and performs, in response to the detection signal being determined to be abnormal in the first abnormality determination, a second abnormality determination that compares a characteristic signal indicative of a characteristic of a sensor device with a second threshold range for grasping a state of the sensor device, and determines that the characteristic signal is abnormal when the characteristic signal is outside the second threshold range and that the sensor device has an abnormality.

## Description

### CROSS REFERENCE TO RELATED APPLICATION

This application is based on Japanese Patent Application No. 2022-184237, filed on November 17, 2022, the contents of which are incorporated herein by reference.

### TECHNICAL FIELD

The present disclosure relates to an equipment state monitoring system that detects an abnormality of an equipment.

### BACKGROUND ART

A piezoelectric device in which a piezoelectric element is disposed in a casing has been proposed (see, for example, Patent Literature 1). Specifically, the piezoelectric element has a vibration region and transmits a detection signal corresponding to sound pressure applied to the vibration region. The piezoelectric device as described above is attached to a processing equipment, a transport equipment, or the like, as the equipment, so that sound pressure generated according to the state of the equipment is applied to the vibration region.

### PRIOR ART LITERATURE

### PATENT LITERATURE

Patent Literature 1: JP 7156558 B2

### SUMMARY OF INVENTION

When the piezoelectric device as described above is attached to an equipment to detect an abnormality in the equipment, for example, it is conceivable to configure the piezoelectric device to include a control unit connected to the piezoelectric element and to have the control unit determine whether or not there is an abnormality in the equipment based on the detection signal. In this case, the control unit compares the detection signal with a predetermined threshold range, and if the detection signal is not within the threshold range, determines that an abnormality has occurred in the equipment.

However, there is a possibility that the detection signal may fall outside the threshold range due to an abnormality occurring in the piezoelectric device itself. Therefore, such an abnormality determination may erroneously determine that an abnormality has occurred in the equipment even though no abnormality has occurred in the equipment.

It is an object of the present disclosure to provide an equipment state monitoring system capable of suppressing an erroneous determination.

According to an aspect of the present disclosure, an equipment state monitoring system includes a sensor device having a sensor element that transmits a detection signal according to a state of an equipment, and a control unit that performs a predetermined processing based on the detection signal, in which the control unit performs a first abnormality determination that compares the detection signal with a first threshold range for grasping the state of the equipment and determines that the detection signal is abnormal when the detection signal is outside the first threshold range, and a second abnormality determination that compares a characteristic signal indicative of a characteristic of the sensor device with a second threshold range for grasping a state of the sensor device when the detection signal is determined to be abnormal in the first abnormality determination and determines that an abnormality has occurred in the sensor device when the characteristic signal is outside the second threshold range.

According to this, when the detection signal is outside the first threshold range, the second abnormality determination is performed to determine whether or not the characteristic signal based on the characteristic of the sensor device is within the second threshold range. Therefore, it is possible to suppress the equipment from being determined to be abnormal even though there is actually an abnormality in the sensor device, and to suppress the erroneous determination of the equipment being abnormal.

A reference numeral in a parenthesis attached to each component indicates an example of the correspondence between the component and a specific component described in embodiments described below.

### BRIEF DESCRIPTION OF DRAWINGS

FIG. 1 is a block diagram of an equipment state monitoring system according to a first embodiment.
FIG. 2 is a cross-sectional view of a piezoelectric element.
FIG. 3 is a plan view of the piezoelectric element.
FIG. 4 is a cross-sectional view of a piezoelectric device.
FIG. 5 is a flowchart executed by a first determination unit.
FIG. 6 is a flowchart executed by a second determination unit.
FIG. 7 is a block diagram of an equipment state monitoring system according to a modified example of the first embodiment.
FIG. 8 s a block diagram of an equipment state monitoring system according to a second embodiment.
FIG. 9 s a plan view of a piezoelectric element.
FIG. 10 is a cross-sectional view of a piezoelectric device.
FIG. 11 is a flowchart executed by a second determination unit.
FIG. 12 is a cross-sectional view of a piezoelectric device according to a modified example of the second embodiment.
FIG. 13 is a block diagram of an equipment state monitoring system according to a third embodiment.
FIG. 14 is a flowchart executed by a second determination unit.

### DESCRIPTION OF EMBODIMENTS

Hereinafter, embodiments of the present disclosure will be described with reference to the drawings. In the following descriptions, parts that are the same or equivalent to each other will be denoted by the same reference numerals throughout the embodiments.

### (First embodiment)

A first embodiment will be described with reference to the drawings. An equipment state monitoring system according to the present embodiment is preferably provided in an equipment that manufactures a specified product and used to detect abnormalities in the equipment. For example, the equipment state monitoring system of the present embodiment is equipped to a processing equipment having a cutting tool, and is used to detect abnormalities such as wear and breakage of the cutting tool. However, the equipment to be determined may be changed as appropriate, and may be a transport equipment or the like.

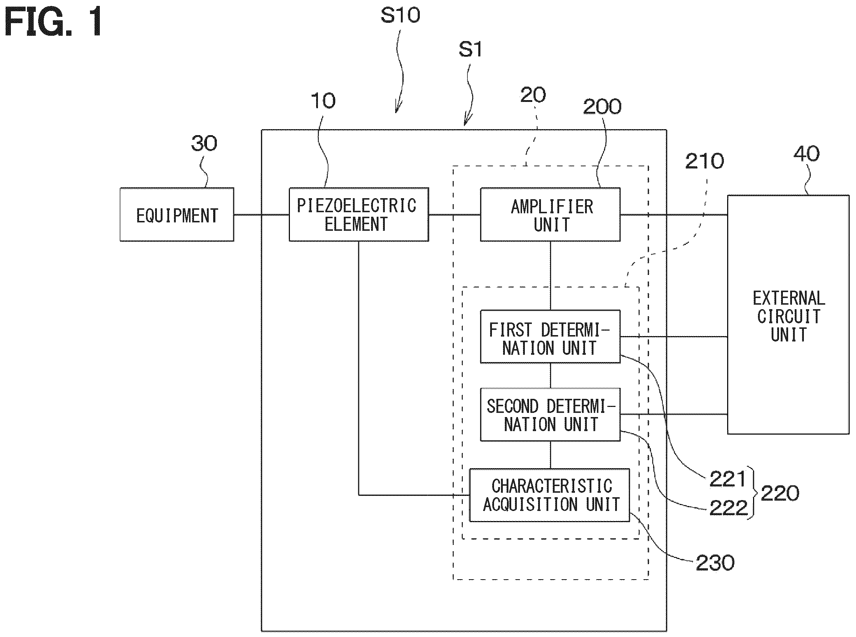

As shown in FIG. 1, an equipment state monitoring system S1 includes a piezoelectric element 10, a circuit unit 20 having a control unit 210, and the like. In the present embodiment, the piezoelectric element 10 and the circuit unit 20 are disposed together in a casing 300, which will be described later, and constitute an integrated piezoelectric device S10. In the present embodiment, the piezoelectric element 10 corresponds to a sensor element.

The piezoelectric device S10 (i.e., the piezoelectric element 10) is equipped to an equipment 30 and outputs a detection signal corresponding to a sound pressure generated in the equipment 30. In the present embodiment, the equipment 30 is a processing equipment having a cutting tool as described above.

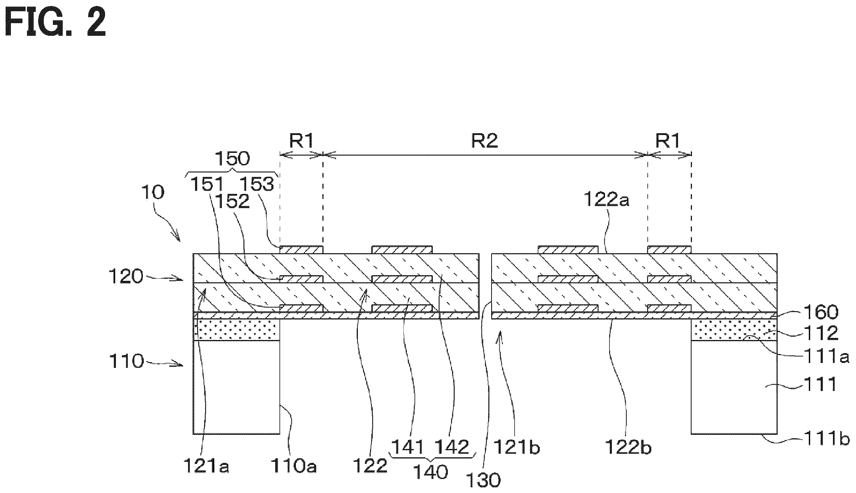

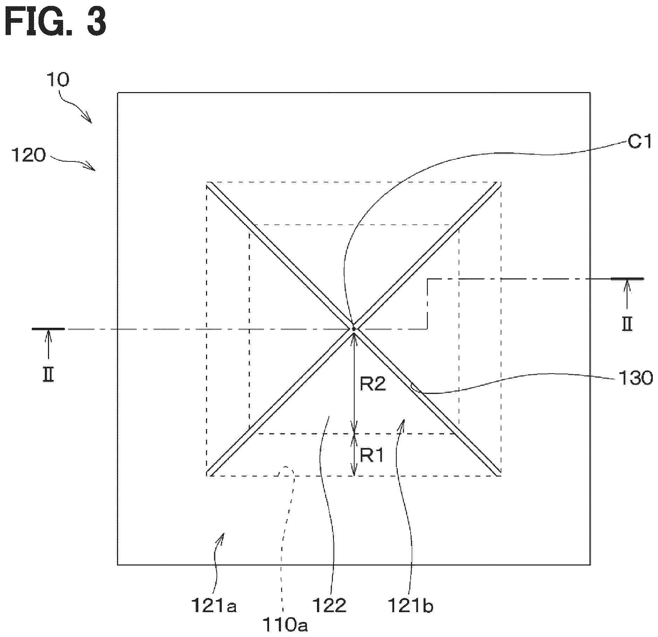

The piezoelectric element 10 of the present embodiment will be described below with reference to FIGS. 2 and 3. The piezoelectric element 10 includes a support body 110 and a vibration unit 120, and has a rectangular shape in a plan view. The support body 110 includes a support substrate 111, which has one surface 111a and another surface 111b, and an insulating film 112, which is formed on the one surface 111a of the support substrate 111. The support substrate 111 is made of, for example, a silicon substrate or the like, and the insulating film 112 is made of, for example, an oxide film or the like.

The vibration unit 120 is disposed on the support body 110. The support body 110 is formed with a recess 110a for floating an inner side of the vibration unit 120. Therefore, the vibration unit 120 has a support region 121a disposed on the support body 110, and a floating region 121b that is connected to the support region 121a and floats above the recess 110a. In the present embodiment, an opening end of the recess 110a on the vibration unit 120 side has a rectangular shape in the plan view. Therefore, the entire floating region 121b has a rectangular shape in the plan view.

The floating region 121b has a slit 130 formed therein, which penetrates the floating region 121b in a thickness direction. The slit 130 of the present embodiment is formed so as to divide the floating region 121b into four parts. More specifically, two slits 130 are formed so as to pass through a center C1 of the floating region 121b and extend toward opposite corners of the floating region 121b. In other words, the slits 130 are formed so as to extend from respective corners of the floating region 121b, which has the rectangular shape in the plan view, toward the center C1, and intersect each other at the center C1. As a result, the floating region 121b is separated into four vibration regions 122 each having a substantially triangular shape in the plan view. In the present embodiment, although not particularly limited, an interval between the vibration regions 122 (i.e., the width of the slit 130) is about 1 µm.

Each vibration region 122 is formed into a cantilever in which an end portion adjacent to the support region 121a is a fixed end and a tip end opposite to the support region 121a is a free end. In the following description, a surface of the vibration region 122 opposite the support body 110 is referred to as one surface 122a of the vibration region 122, and a surface of the vibration region 122 facing the support body 110 is referred to as the other surface 122b of the vibration region 122.

The vibration unit 120 includes a piezoelectric film 140 and an electrode film 150 connected to the piezoelectric film 140. Specifically, the piezoelectric film 140 includes a lower piezoelectric film 141 and an upper piezoelectric film 142 stacked on the lower piezoelectric film 141. The lower piezoelectric film 141 and the upper piezoelectric film 142 are made of lead-free piezoelectric ceramics such as scandium aluminum nitride (ScAlN) or aluminum nitride (AIN).

The electrode film 150 is formed at a predetermined position of the vibration region 122 so as to be connected to the piezoelectric film 140, and is made of molybdenum, copper, platinum, titanium, or the like. In the present embodiment, the electrode film 150 includes a lower electrode film 151 disposed below the lower piezoelectric film 141, an intermediate electrode film 152 disposed between the lower piezoelectric film 141 and the upper piezoelectric film 142, and an upper electrode film 153 disposed above the upper piezoelectric film 142. The lower electrode film 151 and the intermediate electrode film 152 are disposed so as to face each other with the lower piezoelectric film 141 interposed therebetween. The intermediate electrode film 152 and the upper electrode film 153 are disposed so as to face each other with the upper piezoelectric film 142 interposed therebetween. The lower electrode film 151, the intermediate electrode film 152, and the upper electrode film 153 have the same shape in a normal direction to the one surface 122a of the vibration region 122 (hereinafter simply referred to as the normal direction). Note that "in the normal direction to the one surface 122a of the vibration region 122" can be regarded as "when viewed in the normal direction to the one surface 122a of the vibration region 122".

Here, when the vibration region 122 is supported in a cantilever manner as described above, the stress generated when the vibration region 122 (i.e., the piezoelectric film 140) vibrates is likely to be greater on the fixed end side on which the vibration region 122 is supported than on the free end side. For this reason, the vibration region 122 is divided into a first region R1 where the stress is likely to be large and a second region R2 where the stress is likely to be small. In the present embodiment, the electrode film 150 is disposed in each of the first region R1 and the second region R2. The electrode film 150 disposed in the first region R1 and the electrode film 150 disposed in the second region R2 are insulated from each other.

Although not particularly shown, the electrode film 150 disposed in the first region R1 is connected to an electrode portion (not shown) via a wiring or the like disposed in the support region 121a. In the present embodiment, the lower electrode film 151, the intermediate electrode film 152, and the upper electrode film 153 in each vibration region 122 are connected to electrode portions so that the change in charge in the first region R1 of the corresponding vibration region 122 is output as a single detection signal.

The lower electrode film 151, the intermediate electrode film 152, and the upper electrode film 153 disposed in the second region R2 are not electrically connected to the respective electrode portions and are in a floating state. For this reason, although the lower electrode film 151, the intermediate electrode film 152, and the upper electrode film 153 in the second region R2 are not necessarily required, in the present embodiment, these are provided to protect the portions of the lower piezoelectric film 141 and the upper piezoelectric film 142 located in the second region R2.

The lower electrode films 151, the intermediate electrode films 152, and the upper electrode films 153 disposed in the first region R 1 and the second region R 2 are each formed so as not to reach the slit 130. That is, the lower electrode films 151, the intermediate electrode films 152, and the upper electrode films 153 are disposed so as to terminate at positions more to inside than the side surfaces exposed in the slits 130 in the vibration region 122. In other words, the lower electrode films 151, the intermediate electrode films 152, and the upper electrode films 153 are disposed in areas inside than the slits 130 in the normal direction to the one surface 122a of the vibration region 122.

Further, the vibration unit 120 of the present embodiment has a base film 160 on which the lower piezoelectric film 141 and the lower electrode film 151 are disposed. That is, the piezoelectric film 140 and the electrode film 150 are disposed on the support body 110 via the base film 160. In the present embodiment, the other surface 122b of each vibration region 122 is made of the base film 160.

Although the base film 160 is not necessarily required, it is provided to facilitate crystal growth when the lower piezoelectric film 141 and the like are formed. In the present embodiment, the base film 160 is made of aluminum nitride or the like. The piezoelectric film 140 has a thickness of about 1 µm, and the base film 160 has a thickness of about several tens of nm. In other words, the base film 160 is made extremely thin compared to the piezoelectric film 140.

The piezoelectric element 10 of the present embodiment has the configurations as described hereinabove. In such a piezoelectric element 10, when sound pressure is applied to each vibration region 122, each vibration region 122 vibrates. In this case, for example, when the free end of each vibration region 122 is displaced upward, a tensile stress is generated in the lower piezoelectric film 141 and a compressive stress is generated in the upper piezoelectric film 142, so the charges in the lower piezoelectric film 141 and the upper piezoelectric film 142 change. Therefore, the sound pressure applied to the vibration region 122 is detected based on the charges in the lower piezoelectric film 141 and the upper piezoelectric film 142.

At this time, the stress generated in the vibration region 122 (i.e., the piezoelectric film 140) is larger on the fixed end side than on the free end side because the stress is released on the free end side. In other words, on the free end side, less charge is generated, and a signal-to-noise ratio (S/N ratio) is likely to be smaller. For this reason, in the piezoelectric element 10 of the present embodiment, as described above, each vibration region 122 is divided into the first region R1 where the stress is likely to be large and the second region R2 where the stress is likely to be small. In the piezoelectric element 10, the charges generated in the lower piezoelectric film 141 and the upper piezoelectric film 142 located in the first region R1 are extracted from the lower electrode film 151, the upper electrode film 153, and the intermediate electrode film 152 disposed in the first region R1. As a result, it is possible to suppress an increase in the influence of noise.

As shown in FIG. 1, the circuit unit 20 includes an amplifier unit 200 and a control unit 210.

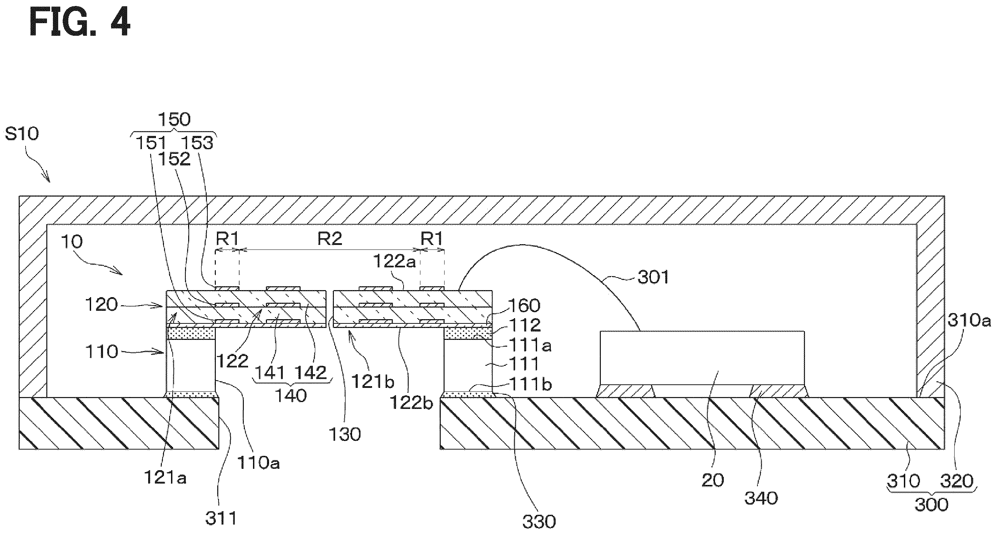

In the present embodiment, the piezoelectric element 10 and the circuit unit 20 are both accommodated in the casing 300 as shown in FIG. 4 so as to form the piezoelectric device S10. Specifically, the casing 300 has a printed circuit board 310 on which the piezoelectric element 10 and the circuit unit 20 are mounted, and a lid portion 320 fixed to the printed circuit board 310 so as to accommodate the piezoelectric element 10 and the circuit unit 20 therein. The printed circuit board 310 can also be considered as a mounted member.

Although not particularly shown, the printed circuit board 310 is configured so that wiring portions, through-hole electrodes and the like are appropriately formed, and also has electronic components such as capacitors mounted thereon as necessary. The piezoelectric element 10 is mounted on the one surface 310a of the printed circuit board 310 so that the other surface 111b of the support substrate 111 faces the one surface 310a of the printed circuit board 310 through a bonding member 330 such as an adhesive. In the present embodiment, the printed circuit board 310 is formed with a through hole 311 at a portion facing the vibration regions 122.

The circuit unit 20 is mounted on the one surface 310a of the printed circuit board 310 via a bonding member 340 made of a conductive material. The piezoelectric element 10 and the circuit unit 20 are electrically connected through a bonding wire 301. The lid portion 320 is made of metal, plastic, resin, or the like, and is fixed to the printed circuit board 310 through a bonding member such as an adhesive (not shown) so as to accommodate the piezoelectric element 10 and the circuit unit 20 therein.

Such a piezoelectric device S10 is disposed so that sound pressure generated from the equipment 30 is applied to the vibration regions 122 via the through hole 311. The piezoelectric element 10 then transmits to the circuit unit 20 a detection signal according to the sound pressure (i.e., pressure) introduced from the through hole 311.

Next, a configuration of the circuit unit 20 of the present embodiment will be described in detail. As described above, the circuit unit 20 includes the amplifier unit 200, the control unit 210 and the like.

When receiving the detection signal from the piezoelectric element 10, the amplifier unit 200 amplifies the detection signal and transmits the amplified detection signal to the control unit 210 and an external circuit unit 40.

The control unit 210 is composed of a microcomputer or the like having a CPU, a memory unit, and the like, the memory unit being composed of a non-transitory tangible storage medium such as a ROM, a RAM, a flash memory, or an HDD. The control unit 210 includes a determination unit 220 and a characteristic acquisition unit 230. CPU is an abbreviation for central processing unit, ROM is an abbreviation for read only memory, RAM is an abbreviation for random access memory, and HDD is an abbreviation for hard disk drive. A storage medium such as a ROM corresponds to a non-transitory tangible storage medium.

The determination unit 220 of the present embodiment has a first determination unit 221 and a second determination unit 222. The first determination unit 221 performs a first abnormality determination by comparing the amplified detection signal with a predetermined first threshold range. Specifically, the first determination unit 221 determines that the detection signal is normal when the detection signal is within the first threshold range, and determines that the detection signal is abnormal when the detection signal is not within the first threshold range. For example, in a case where the state of a cutting tool in the equipment 30 is to be detected, the sound pressure introduced via the through hole 311 increases with an increase in wear of the cutting tool. Therefore, when the detection signal increases and falls outside the first threshold range, the first determination unit 221 determines that the detection signal is abnormal. When determining that the detection signal is abnormal, the first determination unit 221 transmits a characteristic determination signal to the second determination unit 222. When the first determination unit 221 determines that the detection signal is within the first threshold range, the equipment 30 is normal and therefore the first determination unit 221 transmits a normal signal to the external circuit unit 40. The first threshold range is a range for grasping the state of the equipment, and is set appropriately, for example, based on the material, shape, and the like of the cutting tool so that wear of the cutting tool can be detected.

When receiving the characteristic determination signal from the first determination unit 221, the second determination unit 222 transmits a characteristic acquisition signal to the characteristic acquisition unit 230. Then, when receiving a characteristic signal from the characteristic acquisition unit 230 as described below, the second determination unit 222 performs a second abnormality determination by comparing the characteristic signal with a second threshold range. Specifically, the second determination unit 222 determines that the characteristic signal is normal when the characteristic signal is within the second threshold range, and determines that the characteristic signal is abnormal when the characteristic signal is not within the second threshold range. More specifically, when the characteristic signal is within the second threshold range, the second determination unit 222 determines that the piezoelectric device S10 is normal and that the equipment 30 is abnormal, and when the characteristic signal is not within the second threshold range, the second determination unit 222 determines that the piezoelectric device S10 is abnormal and the equipment 30 is normal. In other words, the second determination unit 222 performs a self-diagnosis of the piezoelectric device S10. For example, in the piezoelectric element 10 as described above, if a foreign object adheres to the vibration region 122 or if the vibration region 122 is damaged, the mass increases and the resonant frequency changes. Therefore, the second determination unit 222 determines that an abnormality has occurred when the characteristic signal based on the resonant frequency changes and falls outside the second threshold range. The second threshold range is a range for grasping the state of the piezoelectric device S10, and is set appropriately based on the sensitivity and the like of the vibration region 122.

When determining that the piezoelectric device S10 is normal, the second determination unit 222 transmits to the external circuit unit 40 an equipment abnormality signal indicating that the equipment 30 is abnormal. When determining that the piezoelectric device S10 is abnormal, the second determination unit 222 transmits to the external circuit unit 40 a piezoelectric device abnormality signal indicating that the piezoelectric device S10 is abnormal.

In the present embodiment, the characteristic acquisition unit 230 is configured to include an RLC circuit having a resistor, a coil, a capacitor, and the like. When receiving the characteristic acquisition signal from the second determination unit 222, the characteristic acquisition unit 230 transmits a characteristic signal indicative of the characteristic of the piezoelectric element 10. In the present embodiment, the characteristic acquisition unit 230 transmits the characteristic signal based on the resonance frequency of the vibration region 122 in the piezoelectric element 10 to the second determination unit 222. As described above, the characteristic signal based on the resonance frequency of the vibration region 122 changes due to the foreign object adhering to the vibration region 122, the vibrating region 122 being damaged or the like.

The external circuit unit 40 performs a predetermined processing according to a signal received. For example, the external circuit unit 40 is connected to a display device that can be seen by an operator, and causes the display device to display the states of the equipment 30 and the piezoelectric device S10.

Specifically, when receiving the normal signal from the first determination unit 221, the external circuit unit 40 causes the display device to display information indicating that the equipment 30 and the piezoelectric device S10 are normal. On the other hand, when receiving the equipment abnormality signal from the second determination unit 222, the external circuit unit 40 causes the display device to display information indicating that an abnormality has occurred in the equipment 30. Furthermore, when receiving the piezoelectric device abnormality signal from the second determination unit 222, the external circuit unit 40 causes the display device to display information indicating that an abnormality has occurred in the piezoelectric device S10.

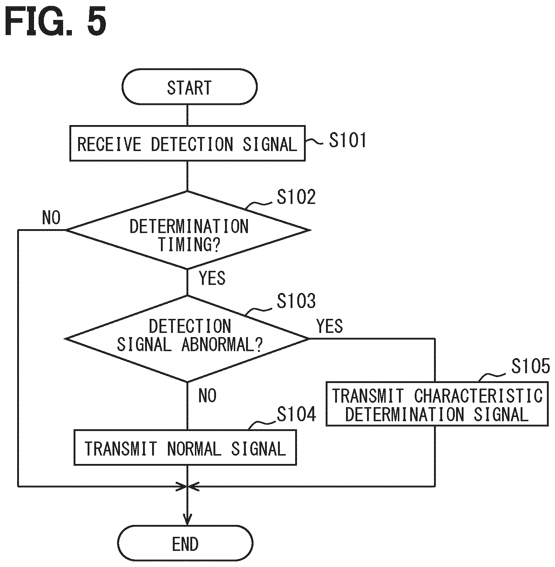

The equipment state monitoring system of the present embodiment have the configurations as described above. Next, operations executed by the control unit 210 will be described. First, an operation of the first determination unit 221 will be described with reference to FIG. 5.

The first determination unit 221 receives, in step S101, the amplified detection signal from the amplifier unit 200. Next, in step S102, the first determination unit 221 determines whether or not it is a timing for determination. For example, the timing for determination may be a timing at which the equipment 30 starts or stops operating, or may be set at predetermined intervals. However, the timing for determination by the first determination unit 221 can be changed as appropriate. When the first determination unit 221 determines that it is not the timing for determination (i.e., step S102: NO), the first determination unit 221 ends the processing.

When the first determination unit 221 determines that it is the timing for determination (i.e., step S102: YES), the first determination unit 221 performs, in step S103, the first abnormality determination by comparing the detection signal with the first threshold range. When the first determination unit 221 determines that the detection signal is within the first threshold range and that there is no abnormality in the detection signal (i.e., step S103: NO), the first determination unit 221 transmits a normal signal to the external circuit unit 40 in step S104 and ends the processing. On the other hand, when the first determination unit 221 determines that the detection signal is outside the first threshold range and that there is an abnormality in the detection signal (i.e., step S103: YES), the first determination unit 221 transmits the characteristic determination signal to the second determination unit 222 in step S105 and ends the processing.

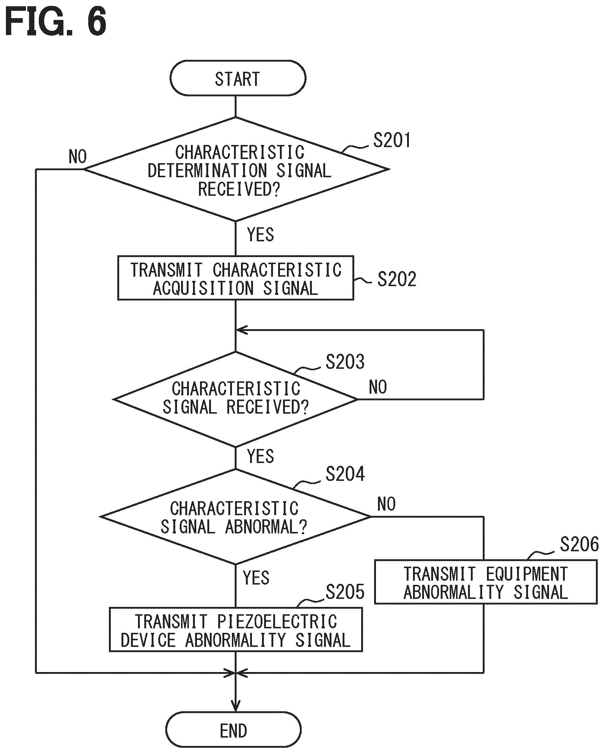

The first determination unit 221 performs the operation as described above. Next, an operation of the second determination unit 222 will be described with reference to FIG. 6.

In step S201, the second determination unit 222 determines whether or not the characteristic determination signal has been received. When the second determination unit 222 determines that the characteristic determination signal has not been received (i.e., step S201: NO), the second determination unit 222 ends the processing. When the second determination unit 222 determines that the characteristic determination signal has been received (i.e., step S201: YES), the second determination unit 222 transmits the characteristic acquisition signal to the characteristic acquisition unit 230 in step S202. As a result, the characteristic acquisition unit 230 transmits the characteristic signal based on the resonance frequency of the vibration region 122 in the piezoelectric element 10 to the second determination unit 222. As described above, the characteristic signal based on the vibration region 122 changes due to the foreign object adhering to the vibration region 122, the vibration region 122 being damaged, or the like.

Next, in step S203, the second determination unit 222 determines whether or not the characteristic signal has been received. When the second determination unit 222 determines that the characteristic signal has not been received (i.e., step S203: NO), the second determination unit 222 performs the process of step S203 again. That is, the second determination unit 222 waits for the reception of the characteristic signal.

When the second determination unit 222 determines that the characteristic signal has been received (i.e., step S203: YES), the second determination unit 222 performs the second abnormality determination in step S204 by comparing the characteristic signal with the second threshold range. That is, the self-diagnosis of the piezoelectric device S10 is performed. Then, when the second determination unit 222 determines that the characteristic signal is not within the second threshold range (i.e., step S204: YES), the characteristic signal is abnormal. Therefore, the second determination unit 222 transmits, in step S205, the piezoelectric device abnormality signal indicating that the piezoelectric device S10 is abnormal to the external circuit unit 40. On the other hand, when the second determination unit 222 determines that the characteristic signal is within the second threshold range (i.e., step S204: NO), the second determination unit 222 determines that there is an abnormality in the equipment 30 because the characteristic signal is normal. Therefore, the second determination unit 222 transmits, in step S206, the equipment abnormality signal indicating that there is an abnormality in the equipment 30 to the external circuit unit 40.

According to the present embodiment described above, when the detection signal falls outside the first threshold range, the second abnormality determination to determine whether the characteristic signal based on the characteristics of the piezoelectric device S10 is within the second threshold range is performed. Therefore, it is possible to suppress the equipment 30 from being determined to be abnormal when an abnormality actually exists in the piezoelectric device S10. In other words, it is possible to suppress the erroneous determination that the equipment 30 is erroneously determined to be abnormal.

### (Modification of First Embodiment)

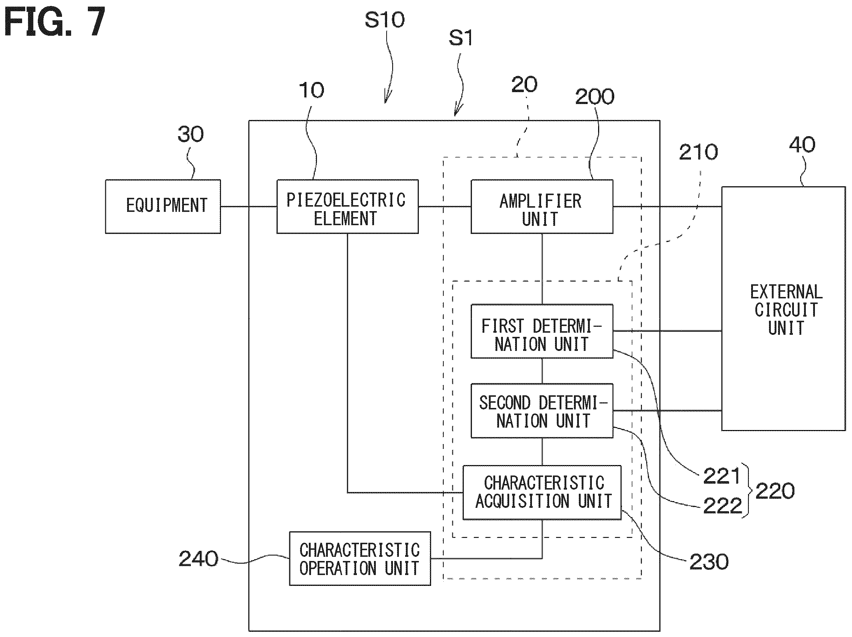

A modification of the first embodiment will now be described. As shown in FIG. 7, a characteristic operation unit 240 may be provided in the first embodiment. The characteristic operation unit 240 is configured with a sound source that generates sound pressure and is connected to the characteristic acquisition unit 230. The characteristic operation unit 240 is configured to be capable of generating sound pressures with multiple different frequencies so as to correspond to the resonant frequencies in the vibration region 122. In this case, the characteristic acquisition unit 230 may be configured to derive, when receiving the characteristic acquisition signal, the characteristic signal based on the resonant frequency of the piezoelectric element 10 based on the detection signal generated by operating the characteristic operation unit 240, and transmit the derived characteristic signal to the second determination unit 222. In this manner, the resonance frequency may be obtained mechanically as the characteristic signal.

### (Second Embodiment)

A second embodiment will be described. In the present embodiment, a restoration operation is performed relative to the first embodiment. The other configurations of the second embodiment are similar to those of the first embodiment, so the description thereof will be omitted here.

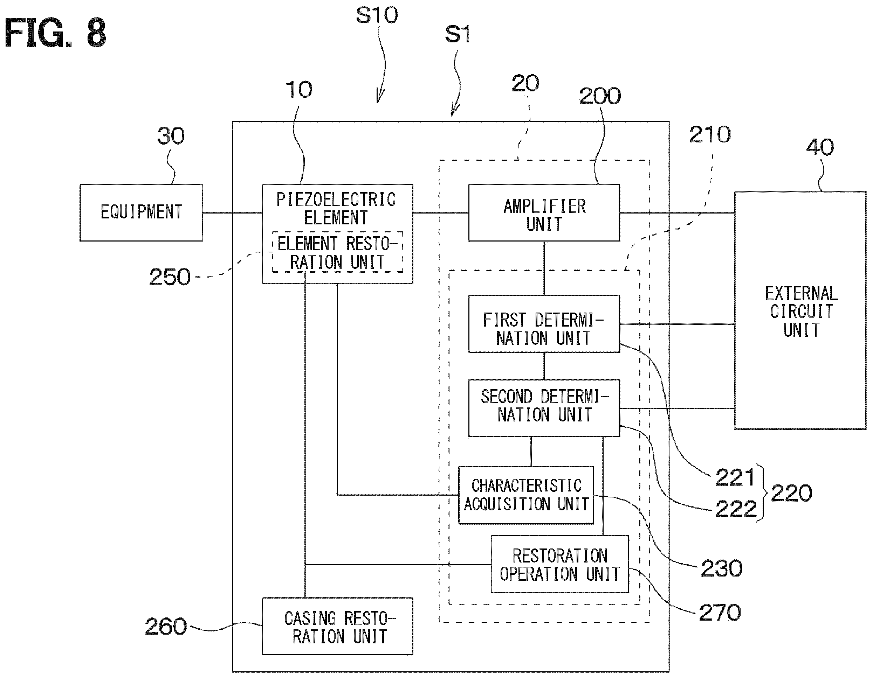

In the present embodiment, as shown in FIG. 8, the equipment state monitoring system S1 further includes an element restoration unit 250, a casing restoration unit 260, and a restoration operation unit 270.

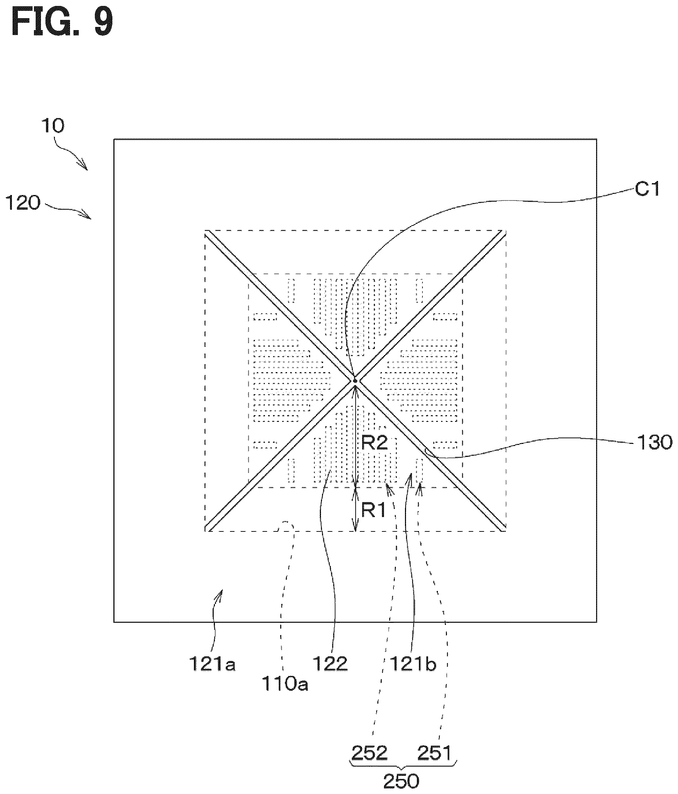

Specifically, as shown in FIG. 9, in the piezoelectric element 10 of the present embodiment, each vibration region 122 is provided with a temperature detection element 251 that outputs a temperature detection signal according to the temperature, and a heat generation element 252 that generates heat when electricity is applied thereto, as the element restoration unit 250. In the present embodiment, the temperature detection element 251 and the heat generation element 252 are formed in the second region R2 of each vibration region 122. More specifically, in the present embodiment, the intermediate electrode film 152 is not formed in the second region R2. The temperature detection element 251 and the heat generation element 252 are disposed in a portion located between the lower piezoelectric film 141 and the upper piezoelectric film 142. That is, the temperature detection element 251 and the heat generation element 252 are disposed in the portion where the intermediate electrode film 152 of the first embodiment is disposed.

The temperature detection element 251 is configured, for example, using a temperature sensitive resistor whose resistance value changes depending on the temperature, and the heat generation element 252 is configured, for example, using a heating resistor that generates heat when electricity is applied thereto. In the present embodiment, the temperature detection element 251 and the heat generation element 252 are made of, for example, platinum.

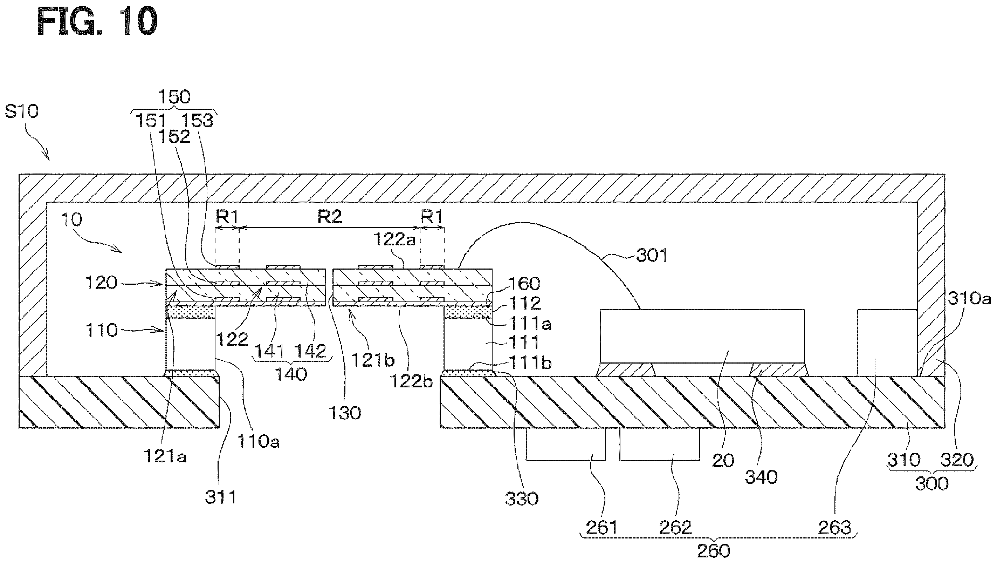

As shown in FIG. 10, the casing 300 is provided with a temperature detection portion 261, a heat generation portion 262, and a vibration portion 263, as the casing restoration unit 260.

The heat generation portion 262 is composed of, for example, a resistance heater or the like. The temperature detection portion 261 is composed of a thermistor or the like. The vibration portion 263 is composed of a piezoelectric element or the like. Although not shown in the figure, the temperature detection portion 261, the heat generation portion 262, and the vibration portion 263 are each electrically connected to the circuit unit 20 via a wire or the like.

FIG. 10 shows an example in which the vibration portion 263 is disposed inside the casing 300, and the temperature detection portion 261 and the heat generation portion 262 are disposed outside the casing 300. However, the locations where these are arranged are not particularly limited, and the vibration portion 263 may be disposed outside the casing 300, and the temperature detection portion 261 and the heat generation portion 262 may be disposed inside the casing 300.

The restoration operation unit 270 is connected to the element restoration unit 250 and the casing restoration unit 260. When receiving a restoration start signal from the second determination unit 222 as described below, the restoration operation unit 270 operates the element restoration unit 250 and the casing restoration unit 260.

Specifically, the restoration operation unit 270 controls the temperature detection element 251 and the heat generation element 252 of the piezoelectric element 10 so that the temperature of the temperature detection element 251 (i.e., the piezoelectric element 10) becomes a predetermined temperature. As a result, in a case where a foreign object such as water is adhered to the vibration region 122, the foreign object such as water can be evaporated. Moreover, the restoration operation unit 270 applies a predetermined voltage to the piezoelectric element 10 to vibrate the vibration region 122. As a result, in a case where a foreign object or the like is adhered to the vibration region 122, the foreign object can be shaken off. In the present embodiment, the target object of the element restoration unit 250 is the piezoelectric element 10.

Similarly, the restoration operation unit 270 controls the temperature detection portion 261 and the heat generation portion 262 disposed on the casing 300 so that the temperature of the temperature detection portion 261 (i.e., the casing 300) becomes a predetermined temperature. As a result, in a case where a foreign object such as water is adhered to the casing 300, the foreign object such as water can be evaporated. Moreover, the restoration operation unit 270 applies a predetermined voltage to the vibration portion 263 disposed on the casing 300 to vibrate the casing 300. As a result, in a case where a foreign object such as water is adhered to casing 300, the foreign object such as water can be shaken off. The foreign object adhering to the casing 300, particularly, the foreign object adhering in the through-hole 311 of the casing 300 changes the sound pressure introduced therein, and thus has a large effect on the detection signal. In the present embodiment, the target object of the casing restoration unit 260 is the casing 300.

When receiving the characteristic determination signal, the second determination unit 222 transmits the restoration start signal to the restoration operation unit 270. As a result, the restoration operation unit 270 performs the operation described above. Then, the second determination unit 222 performs the second abnormality determination by comparing the characteristic signal after the restoration processing with the second threshold range.

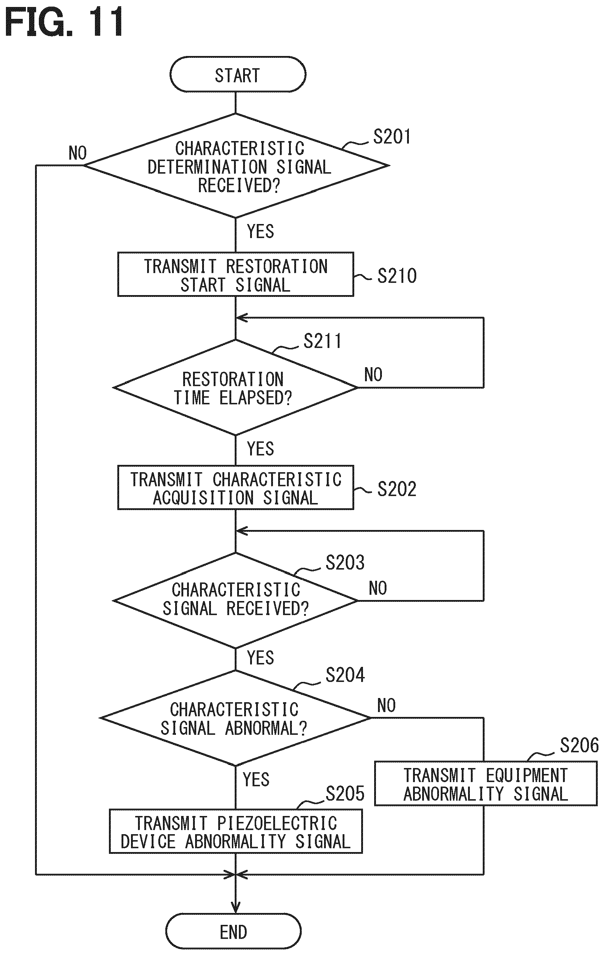

The equipment state monitoring system S1 of the present embodiment has the configurations as described above. Next, the operation of the second determination unit 222 of the present embodiment will be described with reference to FIG. 11. It should be noted that the description of the similar parts to those in the first embodiment will be omitted.

When the second determination unit 222 determines, in step S201, that the characteristic determination signal has been received (i.e., S201: YES), the second determination unit 222 transmits the restoration start signal to the restoration operation unit 270 in step S210. As a result, the restoration operation unit 270 operates the element restoration unit 250 and the casing restoration unit 260 to perform the operation to remove the foreign object if any foreign object is adhered.

Thereafter, in step S211, it is determined whether or not a predetermined restoration time has elapsed. That is, it is determined whether the restoration operation has been completed. When it is determined that the restoration time has not elapsed (i.e., step S211: NO), the process of step S211 is performed again. That is, the second determination unit 222 waits until the restoration time elapses.

When the second determination unit 222 determines that the restoration time has elapsed (that is, step S211: YES), the second determination unit 222 performs the processes of steps S202 to S206. In this case, in the process of step S204, the characteristic signal after the restoration operation is performed is compared with the second threshold value. That is, the characteristic signal in which the adhesion of foreign object or the like is suppressed is compared with the second threshold value. Therefore, the accuracy of determining whether or not the characteristic signal is abnormal can be improved.

According to the present embodiment described above, when the detection signal is outside the first threshold range, the second abnormality determination to determine whether or not the characteristic signal based on the characteristics of the piezoelectric device S10 is within the second threshold range is performed. Therefore, the similar effects to those of the first embodiment can be achieved.
(1) In the present embodiment, the restoration operation of the piezoelectric device S10 is performed before the second abnormality determination is performed. Therefore, it is possible to eliminate an abnormality caused by the foreign object adhering to the piezoelectric device S10, and further to suppress an erroneous determination that the piezoelectric device S10 is abnormal.

### (Modification of Second Embodiment)

A modification of the second embodiment will now be described. In the second embodiment described above, when the second determination unit 222 does not transmit the restoration start signal, the second determination unit 222 may transmit an adjustment signal to the restoration operation unit 270 to control the temperature detection element 251 and the heat generation element 252 so that the vibration region 122 is kept constant at a predetermined temperature. Similarly, when the second determination unit 222 does not transmit the restoration start signal, the second determination unit 222 may transmit an adjustment signal to the restoration operation unit 270 to control the temperature detection portion 261 and the heat generation portion 262 so that the casing 300 is kept constant at a predetermined temperature. As a result, the detection signal from the piezoelectric element 10 becomes the signal in a state where the piezoelectric element 10 is kept at the predetermined temperature. Therefore, variation in detection accuracy can be suppressed.

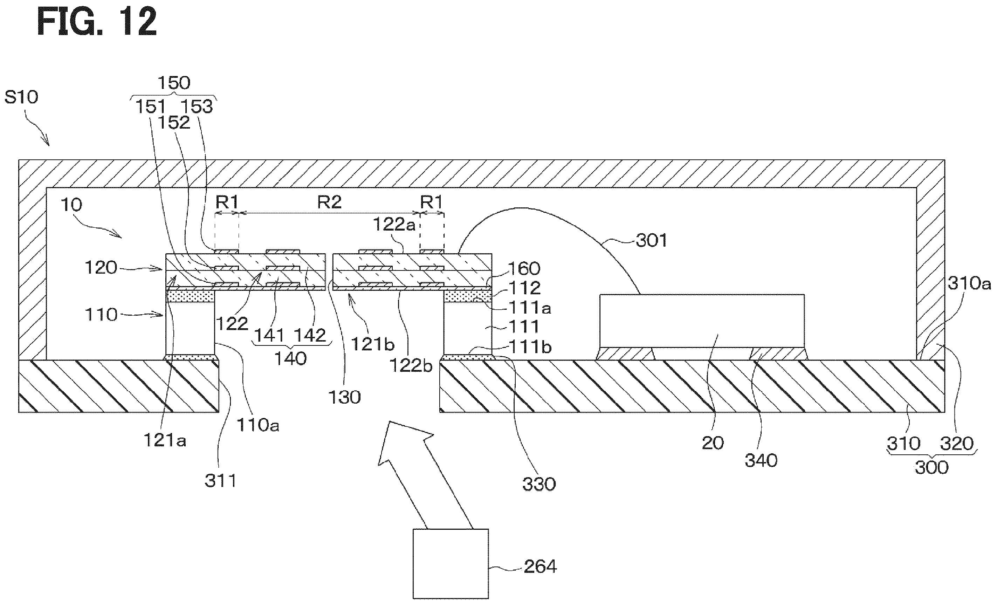

The configuration of the element restoration unit 250 or the casing restoration unit 260 can be changed as appropriate. For example, the casing restoration unit 260 may be provided by an air blower 264 that applies a predetermined wind pressure to the through hole 311 of the casing 300, as shown in FIG. 12. Although not particularly shown, an air blower that applies a wind pressure to the piezoelectric element 10 may be disposed on the casing 300. The element restoration unit 250 may be configured to have only the heat generation element 252 out of the temperature detection element 251 and the heat generation element 252, and the casing restoration unit 260 may be configured to have only the heat generation portion 262 out of the temperature detection portion 261 and the heat generation portion 262.

In the second embodiment described above, an example in which the element restoration unit 250 and the casing restoration unit 260 are provided as the restoration unit has been illustrated. However, a configuration in which only one of the element restoration unit 250 and the casing restoration unit 260 is provided may be applicable.

### (Third embodiment)

A third embodiment will be described. In contrast to the first embodiment, the present embodiment is configured to detect an ambient condition of the equipment 30. The other configurations of the present embodiment are similar to those of the first embodiment, so the description thereof will be omitted here.

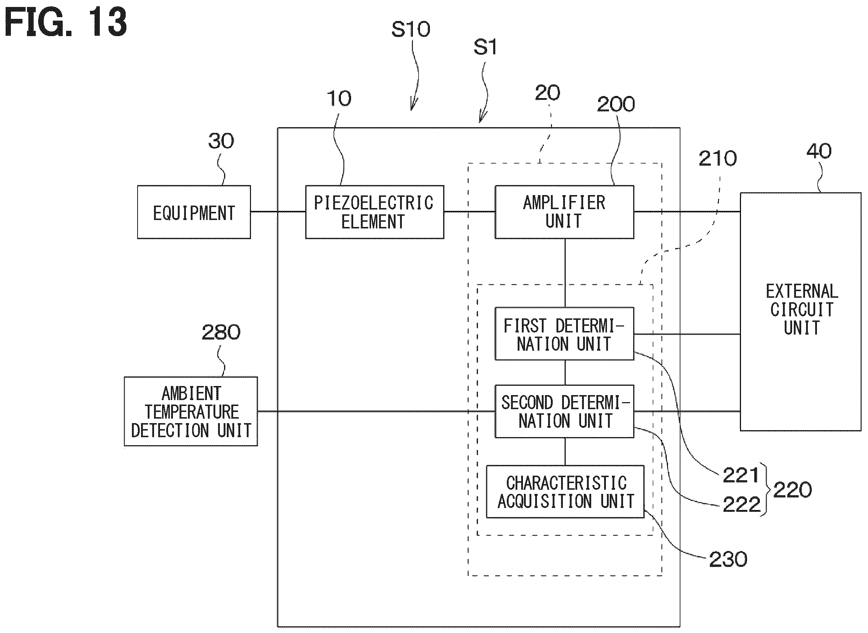

As shown in FIG. 13, the equipment state monitoring system S1 of the present embodiment includes an ambient temperature detection unit 280 as an ambient detection unit. The ambient temperature detection unit 280 is provided by a thermistor or the like, and is connected to the second determination unit 222. The ambient temperature detection unit 280 is disposed, for example, in the vicinity of the equipment 30 and transmits a state signal corresponding to the ambient condition (i.e., temperature) of the equipment 30 to the second determination unit 222.

When receiving the characteristic determination signal, the second determination unit 222 performs a third abnormality determination by comparing the state signal with a third threshold range. Specifically, the second determination unit 222 determines that the state signal is normal when the state signal is within the third threshold range, and determines that the state signal is abnormal when the state signal is not within the third threshold range. More specifically, the second determination unit 222 determines that the ambient condition of the equipment 30 is normal when the state signal is within the third threshold range, and determines that the ambient condition is abnormal when the state signal is not within the third threshold range. When the second determination unit 222 determines that the state signal is not within the third threshold range, the ambient condition is abnormal, and therefore the second determination unit 222 transmits an ambient abnormality signal to the external circuit unit 40.

The ambient condition of the equipment 30 being abnormal refers to a case in which the temperature of the equipment 30 or devices around the equipment 30 is abnormally high, or the like. The third threshold range is a range for grasping the ambient condition of the equipment 30, and is set, for example, based on the range of possible temperatures on a periphery of the equipment 30 during normal use.

When the external circuit unit 40 receives the ambient abnormality signal from the second determination unit 222, the external circuit unit 40 causes the display device to display information indicating that the ambient temperature of the equipment 30 is abnormal.

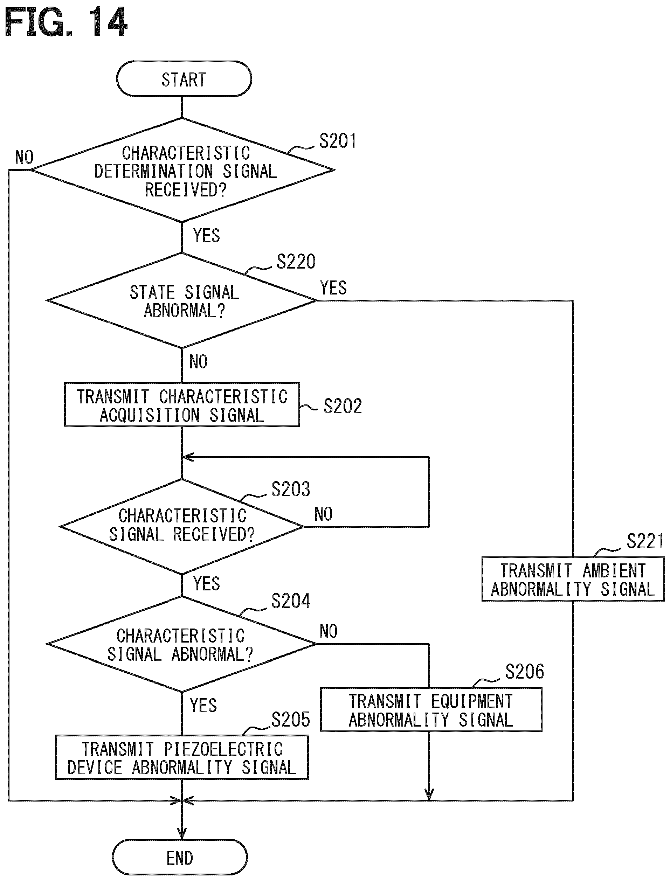

The equipment state monitoring system S1 of the present embodiment has the configurations described above. Next, the operation of the second determination unit 222 of the present embodiment will be described with reference to FIG. 14. It should be noted that the descriptions of the similar parts to those in the first embodiment will be omitted.

When the second determination unit 222 receives the characteristic determination signal in step S201, the second determination unit 222 performs the third abnormality determination in step S220 by comparing the state signal with the third threshold range.

Then, when the second determination unit 222 determines that the state signal is not within the third threshold range (i.e., step S220: YES), since the ambient condition of the equipment 30 is abnormal, the second determination unit 222 transmits in step S221 the ambient abnormality signal to the external circuit unit 40. On the other hand, when the second determination unit 222 determines that the state signal is within the third threshold range (i.e., step S200: NO), the ambient condition of the equipment 30 is normal, and therefore the second determination unit 222 performs the processes of steps S202 to S206.

According to the present embodiment described above, when the detection signal is outside the first threshold range, the second abnormality determination to determine whether or not the characteristic signal based on the characteristics of the piezoelectric device S10 is within the second threshold range is performed. Therefore, the similar effects to those of the first embodiment can be achieved.
(1) In the present embodiment, when the abnormality is detected in the detection signal, the ambient condition is determined. As such, it is possible to take the influence of ambient into account, and thus the erroneous determination is further suppressed.

### (Modification of Third Embodiment)

A modification of the third embodiment will be described. In the third embodiment described above, an example in which the ambient temperature detection unit 280 is provided as the ambient detection unit has been illustrated. However, the configuration of the ambient detection unit can be changed as appropriate, and may be composed of, for example, a humidity detection unit that detects an ambient humidity, a vibration detection unit that detects ambient vibrations, a sound detection unit that detects an ambient sound, and an illuminance detection unit that detects an ambient illuminance.

In the third embodiment, an example in which the ambient temperature detection unit 280 serving as the ambient detection unit is disposed around the equipment 30 has been illustrated. However, the ambient detection unit may be disposed within the piezoelectric device S10. The piezoelectric device S10 outputs the detection signal corresponding to the state of the equipment 30, and is disposed around the equipment 30. Therefore, even if the ambient temperature detection unit 280 is disposed within the piezoelectric device S10, it can be said that the ambient temperature detection unit 280 transmits the state signal corresponding to the state of the ambient of the equipment 30.

In the third embodiment described above, an example in which the third abnormality determination is performed before the second abnormality determination is performed has been illustrated. Alternatively, the third abnormality determination may be performed after the second abnormality determination.

### (Other Embodiments)

Although the present disclosure has been described with reference to the embodiments, it is understood that the present disclosure is not limited to those embodiments or configurations. The present disclosure also encompasses various modifications and variations within the scope of equivalents. Additionally, various combinations and configurations, as well as other combinations and configurations that include only one element, more than one, or less than one, are within the scope and spirit of the present disclosure.

For example, in each of the embodiments described above, the configuration in which the control unit 210 has the first determination unit 221 and the second determination unit 222 has been described as an example. However, the first determination unit 221 and the second determination unit 222 may be integrated into a unit.

In each of the embodiments described above, an example in which the control unit 210 is mounted on the circuit unit 20 has been illustrated. However, the control unit 210 may be provided in the external circuit unit 40, for example. Also, the circuit unit 20 may be disposed outside the casing 300.

In each of the embodiments described above, an example having the piezoelectric element 10 as a sensor element has been described. However, the sensor element may be composed of an acceleration detection element, an angular velocity detection element, a temperature detection element, a light detection element, a humidity detection element, or the like. Further, a plurality of sensor elements may be provided so that detection signals corresponding to different physical quantities are transmitted. For example, a piezoelectric element and a humidity detection element may be provided, and the above determination may be made by combining the detection signals thereof. This can further suppress the erroneous determination.

The control unit and techniques thereof described in the present disclosure may be implemented by a special purpose computer provided by configuring a processor and memory programmed to perform one or more functions embodied in a computer program. Alternatively, the control unit and techniques thereof described in the present disclosure may be implemented in a special purpose computer provided by configuring a processor with one or more special purpose hardware logic circuits. Alternatively, the control unit and techniques thereof described in the present embodiment may be implemented by one or more special purpose computers configured with a processor and memory programmed to perform one or more functions, in combination with a processor configured with one or more hardware logic circuits. The computer program may also be stored in a computer-readable non-transitory tangible storage medium as instructions to be executed by a computer.

### (Disclosure of Present Invention)

The present disclosure described above can be understood, for example, as the following aspects.

### [First aspect]

An equipment state monitoring system includes:
a sensor device (S10) having a sensor element (10) that transmits a detection signal corresponding to a state of an equipment (30); and
a control unit (210) configured to perform a predetermined processing based on the detection signal, and in which
the control unit performs a first abnormality determination that compares the detection signal with a first threshold range for grasping the state of the equipment and determines that the detection signal is abnormal when the detection signal is outside the first threshold range, and performs, in response to the first abnormality determination determining that the detection signal is abnormal, a second abnormality determination that compares a characteristic signal indicative of a characteristic of the sensor device with a second threshold range for grasping a state of the sensor device and determines that the characteristic signal is abnormal when the characteristic signal is outside the second threshold range and that the sensor device has an abnormality.

### [Second Aspect]

The equipment state monitoring system as described in the first aspect, further includes:
a restoration unit (250, 260) equipped to the sensor device, and in which
in response to the first abnormality determination determining that the detection signal is abnormal, the control unit controls the restoration unit to perform a restoration operation for restoring the state of the sensor device before performing the second abnormality determination, and performs the second abnormality determination after the restoration operation is completed.

### [Third Aspect]

In the equipment state monitoring system as described in the first aspect or the second aspect,
the sensor device includes the sensor element and a casing (300) that accommodates the sensor element therein, and
the restoration unit is equipped to the sensor element and serves as a sensor element restoration unit (250) that restores the state of the sensor element.

### [Fourth Aspect]

In the equipment state monitoring system as described in the first aspect or the second aspect,
the sensor device includes the sensor element and a casing (300) that accommodates the sensor element therein, and
the restoration unit is equipped to the casing and serves as a casing restoration unit (260) that restores a state of the casing.

### [Fifth Aspect]

In the equipment state monitoring system as described in the third aspect or the fourth aspect,
the restoration unit is a heat generation element that generates heat to heat a target object.

### [Sixth Aspect]

In the equipment state monitoring system as described in any one of the third to fifth aspects,
the restoration unit is a vibration element that vibrates a target object.

### [Seventh Aspect]

In the equipment state monitoring system according to any one of the third to sixth aspects,
the restoration unit is an element that applies a wind pressure to a target object.

### [Eighth Aspect]

The equipment state monitoring system according to any one of the first to seventh aspects further includes
an ambient detection unit (280) that transmits a state signal corresponding to an ambient of the equipment, and in which
in response the first abnormality determination determining that the detection signal is anormal, the control unit performs a third abnormality determination that compares the state signal with a third threshold range for grasping an ambient condition of the equipment, and determines that an ambient condition of the equipment is abnormal when the state signal is outside the third threshold range.

### [Ninth Aspect]

In the equipment state monitoring system according to any one of the first to eighth aspects
the sensor element is one of a plurality of the sensor elements, and
the plurality of the sensor elements respectively transmit the detection signals corresponding to different physical quantities.

## Claims

1. An equipment state monitoring system comprising:
a sensor device (S10) having a sensor element (10) that transmits a detection signal corresponding to a state of an equipment (30); and
a control unit (210) configured to perform a predetermined processing based on the detection signal, wherein
the control unit performs a first abnormality determination that compares the detection signal with a first threshold range for grasping the state of the equipment and determines that the detection signal is abnormal when the detection signal is outside the first threshold range, and performs, in response to the first abnormality determination determining that the detection signal is abnormal, a second abnormality determination that compares a characteristic signal indicative of a characteristic of the sensor device with a second threshold range for grasping a state of the sensor device and determines that the characteristic signal is abnormal when the characteristic signal is outside the second threshold range and that the sensor device has an abnormality.

2. The equipment state monitoring system according to claim 1, further comprising:
a restoration unit (250, 260) equipped to the sensor device, wherein
in response to the first abnormality determination determining that the detection signal is abnormal, the control unit controls the restoration unit to perform a restoration operation for restoring the state of the sensor device before performing the second abnormality determination, and performs the second abnormality determination after the restoration operation is completed.

3. The equipment state monitoring system according to claim 2, wherein
the sensor device includes the sensor element and a casing (300) that accommodates the sensor element therein, and
the restoration unit is equipped to the sensor element and serves as a sensor element restoration unit (250) that restores the state of the sensor element.

4. The equipment state monitoring system according to claim 2, wherein
the sensor device includes the sensor element and a casing (300) that accommodates the sensor element therein, and
the restoration unit is equipped to the casing and serves as a casing restoration unit (260) that restores a state of the casing.

5. The equipment state monitoring system according to claim 3 or 4, wherein
the restoration unit is a heat generation element that generates heat to heat a target object.

6. The equipment state monitoring system according to claim 3 or 4, wherein
the restoration unit is a vibration element that vibrates a target object.

7. The equipment state monitoring system according to claim 3 or 4, wherein
the restoration unit is an element that applies a wind pressure to a target object.

8. The equipment state monitoring system according to claim 1 or 2, further comprising:
an ambient detection unit (280) that transmits a state signal corresponding to an ambient of the equipment, wherein
in response the first abnormality determination determining that the detection signal is anormal, the control unit performs a third abnormality determination that compares the state signal with a third threshold range for grasping an ambient condition of the equipment, and determines that an ambient condition of the equipment is abnormal when the state signal is outside the third threshold range.

9. The equipment state monitoring system according to claim 1 or 2, wherein
the sensor element is one of a plurality of the sensor elements, and
the plurality of the sensor elements respectively transmit the detection signals corresponding to different physical quantities.
